# EUROPEAN PATENT SPECIFICATION

(11) **EP 2 897 159 B1**
(45) Date of publication and mention of the grant of the patent: **14.06.2017**
(21) Application number: 12884698.7
(22) Date of filing: 31.12.2012
(51) Int. Cl.: H01L 21/328, H01L 21/331, H01L 29/739, H01L 29/66, H01L 29/06, H01L 29/165

(54) **HIGH-VOLTAGE SUPER-JUNCTION IGBT MANUFACTURING METHOD**
HOCHSPANNUNGS-SUPERVERBINDUNGS-IGBT-HERSTELLUNGSVERFAHREN
PROCÉDÉ DE FABRICATION D'UN TRANSISTOR BIPOLAIRE À GRILLE ISOLÉE À SUPER-JONCTION ET À TENSION ÉLEVÉE

(30) Priority: 17.09.2012 CN 201210345024
(43) Date of publication of application: 22.07.2015
(73) Proprietor: Jiangsu R&D Center For Internet Of Things, Wuxi, Jiangsu 214135 (CN); The Institute of Microelectronics of Chinese Academy of Sciences, Beijing 100029 (CN); Jiangsu Cas-IGBT Technology Co., Ltd, Wuxi, Jiangsu 214135 (CN)
(72) Inventor: ZHU, Yangjun, Beijing 100029 (CN); WANG, Bo, Beijing 100029 (CN); LU, Shuojin, Beijing 100029 (CN); HU, Aibin, Beijing 100029 (CN)
(74) Representative: Wilson Gunn
(86) International application number: PCT/CN2012/088053
(87) International publication number: WO 2014/040360

(56) References cited:
- CN-A- 1 411 036
- CN-A- 102 468 284
- DE-A1-102008 061 962
- JP-A- 2000 058 819
- JP-A- 2002 203 963
- US-A1- 2004 135 228
- US-A1- 2005 029 222
- US-A1- 2010 327 314
- US-B1- 6 475 864
- HE, JIN ET AL.: 'Preparation of PT-IGBT with new structure based on SDB' CHINESE JOURNAL OF SEMICONDUCTORS vol. 21, no. 9, September 2000, pages 877 - 881, XP008179155

## Description

### Technical Field

The present invention relates to the field of manufacture of voltage control type power devices, and particularly to a method for manufacturing a high-voltage super junction IGBT.

### Background of the Invention

Due to the unique withstand voltage principle, a super junction structure has excellent performance in characteristic parameter compromise of a device, but this structure process is difficult to achieve. The difficulty of achieving the super junction process mainly lies in how to form a layout with N and P columns arranged alternately at intervals. The longer the N and P columns in interdigital distribution are, the higher the withstand voltage of the device is, the narrower the N and P columns are, the higher the available doping concentration of the column bodies is, and the lower the saturated conductivity voltage drop of the device is, thus, the larger the depth-width ratio of the N and P columns is, the better the performance of the device is. Due to limitation by process conditions, the existing super junction is mainly applied to devices lower than 1200V, a 6500V device needs an effective super junction area with a thickness of about 450 µm, namely, the lengths of the N and P column bodies need to be larger than 450 µm, to ensure the performance of the device, the widths of the columns could not be too large and are generally several micron, in this way, the depth-width ratio of the N and P columns is larger than 100:1, and the N and P columns with this large depth-width ratio are very difficult to manufacture in the existing process on the premise of controlling the cost.

In the patent US7192872B2, a super junction manufacturing process is proposed. In the patent, an N type doped silicon wafer is etched to a saw tooth shape like a wall crenel, a P type doped silicon wafer is etched to a similar shape, the shapes of the two silicon wafers are complementary, then the two silicon wafers are accurately aligned, are inserted together to form interdigital distribution of N and P columns and are bonded into a whole at a high temperature. The N and P columns formed in the patent are limited by one-time etching process and could not be processed to a larger depth-width ratio, thereby only adapting to low-voltage devices lower than 1200V.

US6475864 discloses a method of manufacturing a super-junction semiconductor device. A surface MOSFET structure, including P type base regions, P⁺ type contact region in P type base region, an N⁺ type source region in P type base region, a gate electrode layer and a source electrode, is formed in the surface portion of an N type semiconductor substrate through the usual double diffusion MOSFET manufacturing process. An oxide film is deposited by the CVD method on the back surface of the semiconductor substrate, a resist mask for defining P type partition regions is formed on the oxide film, the oxide film is removed by ion etching, and trenches are dug. The P type epitaxial layers are buried in the trenches by selective epitaxial growth, and the remaining oxide film is removed. The portions of N type semiconductor substrate not etched off remain as N type drift regions, resulting in an alternating conductivity type layer formed of N type drift regions and p-type partition regions. A drain electrode is deposited on the back surface of alternating conductivity type layer.

US2010/0327314 discloses an IGBT device with its collector formed with Ge/Al and associated method of fabrication. The collector is formed on the substrate layer, which is on the back of IGBT, and contains Ge and Al thin films. After thinning and etching the back side of IGBT substrate, Ge and Al are sequentially deposited to form Ge/Al thin films on the back surface of the substrate. An annealing process is then carried out to diffuse Al into Ge thin film layer to form a P-doped Ge layer functioning as the IGBT collector.

US2005/029222 discloses a method of manufacturing a semiconductor device with composite buffer layers. The method includes etching grooves in N type and P type semiconductor wafers respectively. The areas of grooves in N type wafer just correspond to the areas without grooves in P type wafer, and vice versa. The grooves in both N type and P type wafers have the same depth. Two wafers are directly bonded together so that the grooves in one wafer are filled with the grooves in the other wafer.

Then, chemical bonding is implemented. The bonding may also be made through thin dielectric layer (e.g. SiO₂). If necessary, grinding, polishing or chemical mechanical polishing processes are carried out to remove the redundant material.

JP2000 058819 discloses an IGBT provided with a low concentration N type silicon substrate. An N type silicon layer of the impurity concentration of about 1018/cm³ is formed on an area in prescribed depth from the first main face of the silicon substrate.

A high concentration P type collector area is formed on the first main face and is formed of SiGe. A collector electrode is formed on a surface opposite to the N type silicon layer of the collector area. There is also provided a low concentration P type base area, emitter areas and high concentration P type silicon areas which are respectively formed in the areas of prescribed depth from the second main face of the silicon substrate, trenches from the second main face to the inner part of an N base area through the P base area, gate electrodes filled in the trenches, and metallic electrodes connected to the gate electrodes. A collector junction is formed of heterojunction (P+-SiGe/N--Si).

### Summary of the Invention

The technical problem to be solved in the present invention is to provide a method for manufacturing a high-voltage super junction IGBT, which has a larger depth-width ratio and is suitable for high-voltage devices.

To solve the above-mentioned technical problem, the present invention provides a method for manufacturing a high-voltage super junction IGBT, including the following steps:
step 1, respectively etching trenches on N type and P type substrates, wherein the substrates are silicon wafers;
step 2, respectively filling the trenches with epitaxy P type and N type monocrystalline silicon, and flattening and thinning the facades after filling;
step 3, polishing the facades of the silicon wafers, and treating the silicon wafers through acid;
step 4, accurately aligning the two treated silicon wafers and bonding;
step 5, thinning the back surface of the bonded silicon wafer to remove an N layer to expose an N and P alternately distributed layout;
step 6, repeating step 3 and step 4 to bond for the second time;
step 7, after thinning a P type layer on the facade, fabricating the facade of the device;
step 8, thinning an N type layer on the back surface and depositing a P type strain SiGe layer on the back surface to serve as a collector layer such that a p+ (SiGe)/n-(Si) heterojunction is disposed on the back side;
step 9, fabricating a metal layer on the back surface by using metal Al/Ti/Ni/Ag.

Further, in step 3, the treating the silicon wafers through acid includes: firstly cleaning the silicon wafers by using an H₂O-H₂SO₄ mixed solution and deionized water, soaking the silicon wafers in a dilute HF solution, and finally treating the silicon wafers in an H₂SO₄/H₂O₂ mixed solution to form a hydrophilic layer on the surface of each silicon wafer.

Further, the concentration of the dilute HF solution is 5-15%, and the soaking duration is 1-20 min; the H₂O₂ content in the H₂SO₄/H₂O₂ mixed solution is 5-20%, and the treatment temperature is 100-130 °C;
Further, the bonding treatment in step 4 is to bond for 1-10 hours at a temperature of 1000-1300 °C in an N₂, O₂ or inert gas protection environment.

Further, in step 6, step 3, step 4 and step 5 are repeated according to actual voltage grade demand to bond for multiple times.

Further, in step 7, the thinning the facade is to thin a P type layer on the facade until the thickness is smaller than 10 µm.

Further, in step 8, the thinning the back surface is to thin an N type layer on the back surface until the thickness is smaller than 20 µm.

Further, in step 8, the thickness of the collector layer is 15-55 nm, and the Ge content is 5-30%.

Further, in step 9, the thickness of the metal Al layer in the metal layer on the back surface is 0.1-10 µm.

According to the method for manufacturing the high-voltage super junction IGBT provided by the present invention, based on the conventional trenching and filling process, direct silicon wafer bonding technology is introduced to manufacture a super junction structure formed by N and P columns arranged at intervals, which have a large depth-width ratio and are highly doped, in this way, the conductivity modulation effect is not excessively depended to reduce the saturated conductivity voltage drop, and the back injection dosage of the super junction IGBT can be reduced, so as to reduce the turn-off loss of the device, moreover, the highly doped N, P column super junction structure with the large depth-width ratio can be used for a high-voltage power device to improve the overall performance of the device. Meanwhile, a large amount of defects will be left on the bonded surface by the direct silicon wafer bonding technology, and these defects can shorten the service life of a super junction area carrier and also reduce the turn-off loss of the device to a certain degree.

### Brief Description of the Drawings

Fig.1 is a schematic diagram of etching deep grooves on N type and P type substrates in a method for manufacturing a high-voltage super junction IGBT provided by an embodiment of the present invention.
Fig.2 is a schematic diagram of interval arrangement of N and P columns on two different silicon wafers in a method for manufacturing a high-voltage super junction IGBT provided by an embodiment of the present invention.
Fig.3 is a schematic diagram of accurately aligning and bonding two silicon wafers in a method for manufacturing a high-voltage super junction IGBT provided by an embodiment of the present invention.
Fig.4 is a schematic diagram of thinning after bonding in a method for manufacturing a high-voltage super junction IGBT provided by an embodiment of the present invention.
Fig.5 is a schematic diagram of accurately aligning and bonding again after thinning in a method for manufacturing a high-voltage super junction IGBT provided by an embodiment of the present invention.
Fig.6 is a schematic diagram of facade process and back surface process in a method for manufacturing a high-voltage super junction IGBT provided by an embodiment of the present invention.

### Detailed Description of the Embodiments

Embodiments of the present invention provide a method for manufacturing a high-voltage super junction IGBT, including the following steps:
step 1, respectively etching trenches on N type and P type substrates, wherein the substrates are silicon wafers;
step 2, respectively filling the trenches with epitaxy P type and N type monocrystalline silicon, and flattening and thinning the facades after filling;
step 3, polishing the facades of the silicon wafers, and treating the silicon wafers through acid;
step 4, accurately aligning the two treated silicon wafers and bonding;
step 5, thinning the back surface of the bonded silicon wafer to remove an N layer to expose an N and P alternately distributed layout;
step 6, repeating step 3 and step 4 to bond for the second time;
step 7, after thinning a P type layer on the facade, fabricating the facade of the device; step 8, thinning an N type layer on the back surface such that a heterojunction is disposed on the back surface, and depositing a P type strain SiGe layer on the back surface to serve as a collector layer;
step 9, fabricating a metal layer on the back surface by using metal Al/Ti/Ni/Ag;
wherein in step 3, the treating the silicon wafers through acid includes: firstly cleaning the silicon wafers by using an H₂O-H₂SO₄ mixed solution and deionized water, soaking the silicon wafers in a dilute HF solution, and finally treating the silicon wafers in an H₂SO₄/H₂O₂ mixed solution to form a hydrophilic layer on the surface of each silicon wafer;
wherein the concentration of the dilute HF solution is 5-15%, and the soaking duration is 1-20 min; the H₂O₂ content in the H₂SO₄/H₂O₂ mixed solution is 5-20%, and the treatment temperature is 100-130 °C;
wherein the bonding treatment in step 4 is to bond for 1-10 hours at a temperature of 1000-1300 °C in an N₂, O₂ or inert gas protection environment;
wherein in step 6, step 3, step 4 and step 5 are repeated according to actual voltage grade demand to bond for multiple times;
wherein in step 7, the thinning the facade is to thin a P type layer on the facade until the thickness is smaller than 10 µm;
wherein in step 8, the thinning the back surface is to thin an N type layer on the back surface until the thickness is smaller than 20 µm, if a semi-super junction structure is manufactured, the N type layer left after thinning of the back surface can be thicker, and even possibly the back surface is not thinned and the entire N type layer is left; wherein in step 8, the thickness of the collector layer is 15-55 nm, and the Ge content is 5-30%;
wherein in step 9, the thickness of the metal Al layer in the metal layer on the back surface is 0.1-10 µm.

### Embodiment 1 -An example that is useful for understanding the invention

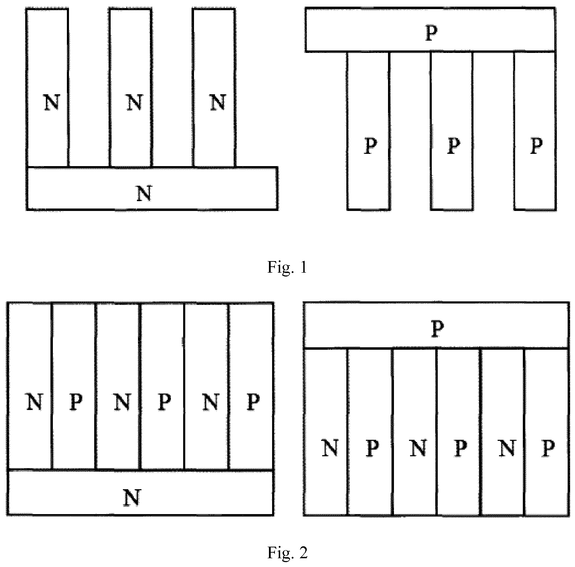

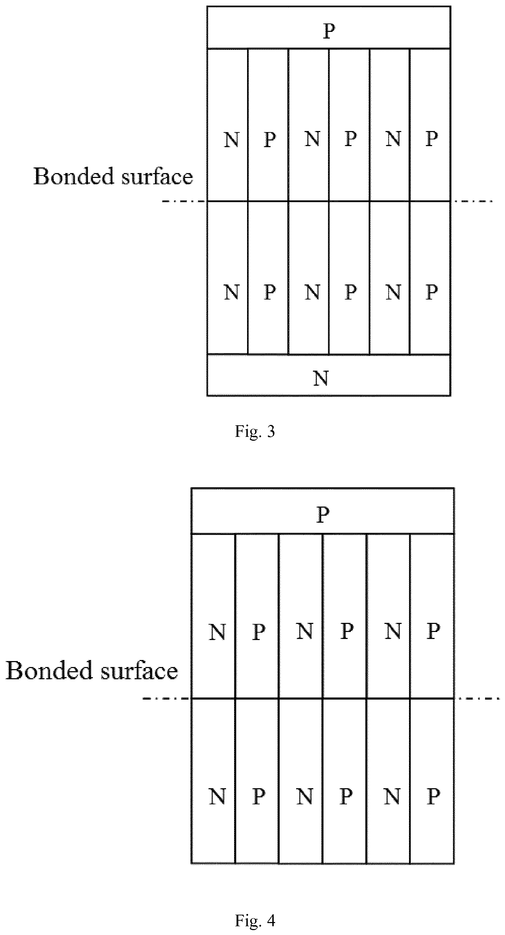

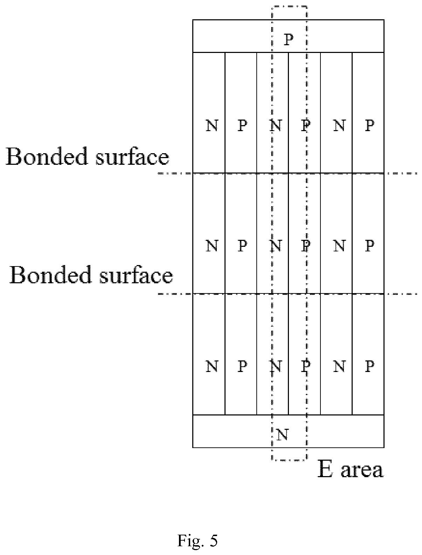

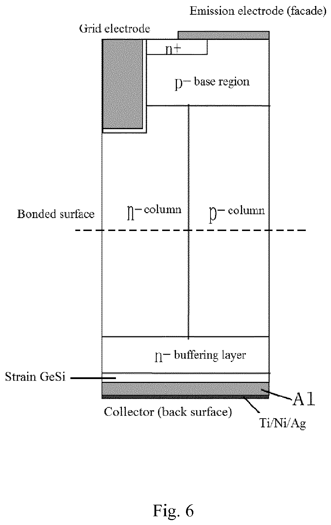

Trenches with widths of 1.5 µm and depths of 60 µm are respectively etched on N type and P type substrates through a conventional etching process with maximum trench depth-to-width ratio of 40:1, as shown in Fig.1; the trenches are respectively filled with epitaxy P type and N type monocrystalline silicon, and the thickness of epitaxy is 0.9 micron. After the filling treatment, the facades are flattened and thinned to remove redundant fillers, in order to form the morphology as shown in Fig.2; the facades of silicon wafers are polished to mirror surfaces, the surfaces of the silicon wafers are respectively cleaned by an H₂O-H₂SO₄ mixed solution and deionized water, then the silicon wafers are soaked in a 15% dilute HF solution for 20 min and are put in an H₂SO₄/H₂O₂ mixed solution with H₂O₂ content of 20% to form a hydrophilic layer on each surface, wherein the treatment temperature is 100 °C. The two silicon wafers with interfaces treated are accurately aligned and are overlapped in an ultraclean environment at room temperature, as shown in Fig.3, then the overlapped silicon wafer is bonded for 2 hours at a temperature of 1200 °C in an N₂, O₂ or inert gas protection environment; then, the facade is thinned, a P type layer on the facade is thinned to 5 µm, the facade of a device is fabricated according to the conventional IGBT process as shown in Fig.6 (Fig.6 is amplified representation of an E area in Fig.5), an N type layer on the back surface is thinned to 8 µm, and a P type strain SiGe layer is deposited on the back surface to serve as a collector layer, wherein the thickness of the P type strain SiGe layer is 15 nm and the Ge content is 30%. Metal Al/Ti/Ni/Ag is used as the back surface metal, wherein an Al layer is particularly thicker and is 6 µm thick for improving the short circuit tolerance.

The super junction IGBT manufactured by the process can be applicable to 1700V devices.

### Embodiment 2 - Part of the invention

Trenches with widths of 1.5 µm and depths of 150 µm are respectively etched on N type and P type substrates through a conventional etching process with maximum trench depth-to-width ratio of 100:1, as shown in Fig.1; the trenches are respectively filled with epitaxy P type and N type monocrystalline silicon, and the thickness of epitaxy is 0.9 micron. After the filling treatment, the facades are flattened and thinned to remove redundant fillers, in order to form the morphology as shown in Fig.2; the facades of silicon wafers are polished to mirror surfaces, the surfaces of the silicon wafers are cleaned by an H₂O-H₂SO₄ mixed solution and deionized water, then the silicon wafers are soaked in a 10% dilute HF solution for 15 min and are put in an H₂SO₄/H₂O₂ mixed solution with H₂O₂ content of 15% to form a hydrophilic layer on each surface, wherein the treatment temperature is 130 °C. The two silicon wafers with interfaces treated are accurately aligned and are overlapped in an ultraclean environment at room temperature, as shown in Fig.3, then the overlapped silicon wafer is bonded for 7 hours at a temperature of 1000 °C in an N₂, O₂ or inert gas protection environment; then, the back surface of the bonded silicon wafer is thinned to remove the N layer and to expose the morphology with N, P arranged at intervals, as shown in Fig.4; and step 3 and step 4 are repeated to bond for the second time, in order to form the morphology as shown in Fig.5. Then, the facade is thinned, a P type layer on the facade is thinned to 6 µm, the facade of a device is fabricated according to the conventional IGBT process as shown in Fig.6 (Fig.6 is amplified representation of an E area in Fig.5), an N type layer on the back surface is thinned to 15 µm, and a P type strain SiGe layer is deposited on the back surface to serve as a collector layer, wherein the thickness of the P type strain SiGe layer is 55 nm and the Ge content is 5%. Metal A1/Ti/Ni/Ag is used as the back surface metal, wherein an Al layer is particularly thicker and is 700 µm thick for improving the short circuit tolerance.

The super junction IGBT manufactured by the process can be applicable to 6500V devices.

### Embodiment 3- Part of the invention

Trenches with widths of 2 µm and depths of 60 µm are respectively etched on N type and P type substrates through a conventional etching process with maximum trench depth-to-width ratio of 30:1, as shown in Fig.1; the trenches are respectively filled with epitaxy P type and N type monocrystalline silicon, and the thickness of epitaxy is 1.2 µm. After the filling treatment, the facades are flattened and thinned to remove redundant fillers, in order to form the morphology as shown in Fig.2; the facades of silicon wafers are polished to mirror surfaces, the surfaces of the silicon wafers are cleaned by an H₂O-H₂SO₄ mixed solution and deionized water, then the silicon wafers are soaked in a 5% dilute HF solution for 10 min and are put in an H₂SO₄/H₂O₂ mixed solution with H₂O₂ content of 15% to form a hydrophilic layer on each surface, wherein the treatment temperature is 110 °C. The two silicon wafers with interfaces treated are accurately aligned and are overlapped in an ultraclean environment at room temperature, as shown in Fig.3, then the overlapped silicon wafer is bonded for 5 hours at a temperature of 1100 °C in an N₂, O₂ or inert gas protection environment; then, the back surface of the bonded silicon wafer is thinned to remove the N layer and to expose the morphology with N, P arranged at intervals, as shown in Fig.4; and step 3 and step 4 are repeated to bond for the second time, in order to form the morphology as shown in Fig.5, step 3 and step 4 are repeated again to bond for the third time, and fourth bonding is performed after the third time bonding to finally form N, P type columns with heights of 240 µm. Then, the facade is thinned, a P type layer on the facade is thinned to 5 µm, the thickness is generally smaller than 10 µm, the facade of a device is fabricated according to the conventional IGBT process as shown in Fig.6 (Fig.6 is amplified representation of an E area in Fig.5), an N type layer on the back surface is thinned to 10 µm, and a P type strain SiGe layer is deposited on the back surface to serve as a collector layer, wherein the thickness of the P type strain SiGe layer is 25 nm and the Ge content is 20%. Metal Al/Ti/Ni/Ag is used as the back surface metal, wherein an Al layer is thicker and is 1.2 µm thick for improving the short circuit tolerance.

The super junction IGBT manufactured by the process can be applicable to 3300V devices.

### Embodiment 4- Part of the invention

Trenches with widths of 2.2 µm and depths of 110 µm are respectively etched on N type and P type substrates through a conventional etching process with maximum trench depth-to-width ratio of 50:1, as shown in Fig.1; the trenches are respectively filled with epitaxy P type and N type monocrystalline silicon, and the thickness of epitaxy is 1.4 µm. After the filling treatment, the facades are flattened and thinned to remove redundant fillers, in order to form the morphology as shown in Fig.2; the facades of silicon wafers are polished to mirror surfaces, the surfaces of the silicon wafers are cleaned by an H₂O-H₂SO₄ mixed solution and deionized water, then the silicon wafers are soaked in a 5-15% dilute HF solution for 1-20 min and are put in an H₂SO₄/H₂O₂ mixed solution with H₂O₂ content of 20% to form a hydrophilic layer on each surface, wherein the treatment temperature is 100 °C. The two silicon wafers with interfaces treated are accurately aligned and are overlapped in an ultraclean environment at room temperature, as shown in Fig.3, then the overlapped silicon wafer is bonded for 8 hours at a temperature of 1000 °C in an N₂, O₂ or inert gas protection environment; then, the back surface of the bonded silicon wafer is thinned to remove the N layer and to expose the morphology with N, P arranged at intervals, as shown in Fig.4; and step 3 and step 4 are repeated to bond for the second time, in order to form the morphology as shown in Fig.5. Then, the facade is thinned, a P type layer on the facade is thinned to 5.5 µm, the facade of a device is fabricated according to the conventional IGBT process as shown in Fig.6 (Fig.6 is amplified representation of an E area in Fig.5), an N type layer on the back surface is thinned to 13 µm, and a P type strain SiGe layer is deposited on the back surface to serve as a collector layer, wherein the thickness of the P type strain SiGe layer is 15 nm and the Ge content is 15%. Metal Al/Ti/Ni/Ag is used as the back surface metal, wherein an Al layer is thicker and is 1 micron thick for improving the short circuit tolerance.

The super junction IGBT manufactured by the process can be applicable to 4500V devices.

According to the method for manufacturing the high-voltage super junction IGBT provided by the present invention, based on the conventional trenching and filling process, direct silicon wafer bonding technology is introduced to manufacture a super junction structure formed by N and P columns, which have a large depth-width ratio, are highly doped and are arranged at intervals. A narrower column body can be used for improving the available doping concentration of the column body, to reduce the saturated conductivity voltage drop of super junction devices. For the super junction IGBT, the saturated conductivity voltage drop of the device is reduced without excessively depending on the conductivity modulation effect, that is, under the same saturated conductivity voltage drop, the back injection dosage of the super junction IGBT is lower, which reduces the turn-off loss of the device. In addition, a longer column body can effectively prolong the super junction area in the longitudinal direction to improve the withstand voltage of the device, the highly doped N, P column super junction structure with a large depth-width ratio manufactured by the process can be used for improving the overall performance of a high-voltage power device. Meanwhile, a large amount of defects will be left on the bonded surface by the direct silicon wafer bonding technology (SDB), and these defects can shorten the service life of a super junction area carrier and reduce the turn-off loss of the device to a certain degree.

The collector material is a strain SiGe material, the main feature of a p+ (SiGe)/n-(Si) heterojunction is forbidden band shifting up, namely a valence band offset is much larger than a conduction band offset, ΔEc=0. 02eV, ΔEv=0. 74xeV, and x refers to the Ge content in the p+ (SiGe) layer. Thus, the potential barrier of a hole is much higher than the potential barrier of an electron, current passing by the potential barrier is mainly electronic current, hole current can be omitted, in this way, the carriers stored in a base region are decreased, and the cut-off loss of the device is reduced.

The back surface metal adopts Al/Ti/Ni/Ag, the specific heat capacity of Al is 0.88KJ/Kg.°C, which is relatively large in common metals of semiconductor technology, when the Al layer is thicker and is tens to hundreds of microns thick, the thermal capacity of the Al layer will be very large, which increases the thermal capacity of the entire chip, reinforces the thermal shock resistance and can effectively improve the short circuit tolerance of the IGBT.

The above embodiments are described by way of example only. Many variations are possible without departing from the scope of the invention as defined in the appended claims.

## Claims

1. A method for manufacturing a high-voltage super junction IGBT, comprising the following steps:
step 1, respectively etching trenches on N type and P type substrates, wherein the substrates are silicon wafers;
step 2, respectively filling the trenches with epitaxy P type and N type monocrystalline silicon, and flattening and thinning the facades after filling;
step 3, polishing the facades of the silicon wafers, and treating the silicon wafers through acid;
step 4, accurately aligning the two treated silicon wafers and bonding;
step 5, thinning the back surface of the bonded silicon wafer to remove an N layer to expose an N and P alternately distributed layout;
step 6, repeating step 3 and step 4 to bond for the second time;
step 7, after thinning a P type layer on the facade, fabricating the facade of the device;
step 8, thinning an N type layer on the back surface and depositing a P type strain SiGe layer on the back surface to serve as a collector layer such that a p+ (SiGe)/n-(Si) heterojunction is disposed on the back side;
step 9, fabricating a metal layer on the back surface by using metal Al/Ti/Ni/Ag.

2. The manufacturing method of claim 1, wherein in step 3, the treating the silicon wafers through acid comprises: firstly cleaning the silicon wafers by using an H₂O-H₂SO₄ mixed solution and deionized water, soaking the silicon wafers in a dilute HF solution, and finally treating the silicon wafers in an H₂SO₄/H₂O₂ mixed solution to form a hydrophilic layer on the surface of each silicon wafer.

3. The manufacturing method of claim 2, wherein the concentration of the dilute HF solution is 5-15%, and the soaking duration is 1-20 min; the H₂O₂ content in the H₂SO₄/H₂O₂ mixed solution is 5-20%, and the treatment temperature is 100-130 °C.

4. The manufacturing method of claim 1, wherein the bonding treatment in step 4 is to bond for 1-10 hours at a temperature of 1000-1300 °C in an N₂, O₂ or inert gas protection environment.

5. The manufacturing method of claim 1, wherein in step 6, step 3, step 4 and step 5 are repeated according to actual voltage grade demand to bond for multiple times.

6. The manufacturing method of claim 1, wherein in step 7, the thinning the P type layer on the facade is until the thickness is smaller than 10 µm.

7. The manufacturing method of claim 1, wherein in step 8, the thinning the N type layer on the back surface is until the thickness is smaller than 20 µm.

8. The manufacturing method of claim 1, wherein in step 8, the thickness of the collector layer is 15-55 nm, and the Ge content is 5-30%.

9. The manufacturing method of claim 1, wherein in step 9, the thickness of the metal Al layer in the metal layer on the back surface is 0.1-10 µm.

## Patentansprüche

1. Verfahren zur Herstellung eines Hochspannungs-Super-Junction-IGBT, aufweisend die folgende Schritte:
Schritt 1, jeweils ätzen von Furchen auf N - und P - Typ - Substraten, wobei die Substrate Silicium-Wafer sind;
Schritt 2, jeweils Füllen der Furchen mit Epitaxie P-Typ und N-Typ Monokristallinem Silizium und ebnen und dünnen der Fassaden nach dem Füllen;
Schritt 3, polieren der Fassaden der Silicium-Wafer und Behandeln der Silicium-Wafer mit Säure;
Schritt 4, exaktes Ausrichten und Verbinden der beiden behandelten Silicium-Wafer;
Schritt 5, dünnen der rückseitigen Oberfläche des verbundenen Siliziumwafers, zum Entfernen einer N-Schicht wodurch ein N und P abwechselnd verteiltes Layout freigelegt wird;
Schritt 6, wiederholen von Schritt 3 und Schritt 4, um ein zweites Mal zu verbinden;
Schritt 7, nach dem Dünnen einer P-Typ-Schicht auf der Fassade, Erzeugen der Fassade der Vorrichtung;
Schritt 8, dünnen einer N-Typ-Schicht auf der rückseitigen Oberfläche und Abscheiden einer verspannten P-Typ SiGe-Schicht auf der rückseitigen Oberfläche, zum Dienen als Kollektorschicht, so dass ein p+ (SiGe)/n-(Si)-Heteroübergang auf der rückseitigen Oberfläche angeordnet ist;
Schritt 9, herstellen einer Metallschicht auf der rückseitigen Oberfläche unter Verwendung von Al / Ti / Ni / Ag Metall.

2. Herstellungsverfahren nach Anspruch 1,
wobei in Schritt 3 die Behandlung des Siliciums Wafer durch Säure umfasst: zuerst Reinigung der Silicium-Wafer unter Verwendung einer H₂O-H₂SO₄-Mischlösung und entionisiertem Wasser, Tauchbaden der Silicium-Wafer in einer verdünnten HF-Lösung und schließlich Behandeln der Silicium-Wafer in einer H₂SO₄/H₂O₂-Mischlösung, zum Bilden einer hydrophilen Schicht auf der Oberfläche jedes Siliziumwafers.

3. Herstellungsverfahren nach Anspruch 2,
wobei die Konzentration des verdünnten HF-Lösung 5-15% beträgt und die Tauchbaddauer 1-20 min beträgt; der H₂0₂-Gehalt in der H₂SO₄/H₂O₂ Mischlösung 5-20% beträgt und die Behandlungstemperatur 100-130 °C beträgt.

4. Herstellungsverfahren nach Anspruch 1,
wobei die Verbindungsbehandlung in Schritt 4 das Verbinden für 1-10 Stunden bei einer Temperatur von 1000-1300 ° C in einem N₂, O₂ oder Inertgas Schutzumgebung aufweist.

5. Herstellungsverfahren nach Anspruch 1,
wobei in Schritt 6, Schritt 3, Schritt 4 und Schritt 5 nach dem tatsächlichen Bedarf an Spannungsgefälle zum mehrfachen Verbinden wiederholt werden.

6. Herstellungsverfahren nach Anspruch 1,
wobei in Schritt 7 das Dünnen der P-Typ Schicht auf der Fassade erfolgt, bis die Dicke kleiner als 10 µm ist.

7. Herstellungsverfahren nach Anspruch 1,
wobei in Schritt 8 das Dünnen der N-Typ Schicht auf der Rückseite erfolgt, bis die Dicke kleiner als 20 µm ist.

8. Herstellungsverfahren nach Anspruch 1,
wobei in Schritt 8 die Dicke der Kollektorschicht 15-55 nm ist und der Ge-Gehalt 5-30% ist.

9. Herstellungsverfahren nach Anspruch 1,
wobei in Schritt 9 die Dicke der Al-Metallschicht in der Metallschicht auf der Rückseiten Oberfläche 0,1-10 µm ist

## Revendications

1. Procédé de fabrication d'un IGBT à super jonction et à haute tension, comprenant les stades suivants :
stade 1, ménager respectivement, par attaque, des sillons sur des substrats de type N et de type P, les substrats étant des tranches de silicium ;
stade 2, remplir respectivement les sillons de silicium monocristallin épitaxial de type P et de type N, et aplatir et amincir les façades après remplissage ;
stade 3, polir les façades des tranches de silicium et traiter les tranches de silicium par de l'acide ;
stade 4, aligner avec précision les deux tranches de silicium traitées et souder ;
stade 5, amincir la surface arrière de la tranche de silicium soudée pour éliminer une couche N, afin de mettre à nu une structure N et P répartie en alternance ;
stade 6, répéter le stade 3 et le stade 4 pour souder pour la deuxième fois ;
stade 7, après avoir aminci une couche de type P sur la façade, fabriquer la façade du dispositif ;
stade 8, amincir une couche de type N sur la surface arrière et déposer une couche SiGe strain de type P sur la surface arrière pour servir de couche de collecteur, de manière à ce qu'une hétérojonction (SiGe)p+/(Si)n soit disposée sur la face arrière ;
stade 9, fabriquer une couche métallique sur la surface arrière en utilisant de l'Al/Ti/Ni/Ag métallique.

2. Procédé de fabrication suivant la revendication 1, dans lequel, dans le stade (3), le traitement des tranches de silicium par de l'acide comprend : premièrement, nettoyer les tranches de silicium en utilisant une solution mixte H₂O-H₂SO₄ et de l'eau déminéralisée, immerger les tranches de silicium dans une solution diluée de HF, et finalement traiter les tranches de silicium dans une solution mixte de H₂SO₄/H₂O₂ pour former une couche hydrophile à la surface de chaque tranche de silicium.

3. Procédé de fabrication suivant la revendication 2, dans lequel la concentration de la solution diluée de HF va de 5 à 15% et la durée d'immersion va de 1 à 20 min ; la teneur en H₂O₂ de la solution mixte de H₂SO₄/H₂O₂ va de 5 à 20%, et la température de traitement va de 100 à 130°C.

4. Procédé de fabrication suivant la revendication 1, dans lequel le traitement de soudure au stade 4 consiste à souder pendant 1 à 10 heures à une température de 1 000 à 1 300°C dans une atmosphère de protection de N₂, de O₂ ou de gaz inerte.

5. Procédé de fabrication suivant la revendication 1, dans lequel, dans le stade 6, le stade 3 et le stade 5 sont répétés en fonction de l'exigence réelle de degré de tension pour souder plusieurs fois.

6. Procédé de fabrication suivant la revendication 1, dans lequel, dans le stade 7, l'amincissement de la couche de type P sur la façade s'effectue jusqu'à ce que l'épaisseur soit plus petite que 10 µm.

7. Procédé de fabrication suivant la revendication 1, dans lequel, dans le stade 8, l'amincissement de la couche de type N sur la surface arrière s'effectue jusqu'à ce que l'épaisseur soit plus petite que 20 µm.

8. Procédé de fabrication suivant la revendication 1, dans lequel, dans le stade 8, l'épaisseur de la couche de collecteur va de 15 à 55 nm, et la teneur en Ge va de 5 à 30%.

9. Procédé de fabrication suivant la revendication 1, dans lequel, dans le stade 9, l'épaisseur de la couche d'AL métallique, dans la couche métallique sur la face arrière, va de 0,1 à 10 µm .
